**Europäisches Patentamt**

**European Patent Office**

**Office européen des brevets**

(11) Veröffentlichungsnummer: **0 087 797**

**A2**

(12) # EUROPÄISCHE PATENTANMELDUNG

(21) Anmeldenummer: **83101956.7**

(22) Anmeldetag: **28.02.83**

(51) Int. Cl.³: **H 01 L 21/68**

(30) Priorität: **02.03.82 DE 3207458**

(43) Veröffentlichungstag der Anmeldung:
**07.09.83 Patentblatt 83/36**

(84) Benannte Vertragsstaaten:
**AT BE CH DE FR GB IT LI NL**

(71) Anmelder: **SIEMENS AKTIENGESELLSCHAFT**
**Berlin und München Wittelsbacherplatz 2**
**D-8000 München 2(DE)**

(72) Erfinder: **Fritz, Otmar, Dipl.-Ing.**
**Johann-Hackl-Ring 64**
**D-8011 Neukeferloh(DE)**

(54) **Halterung für die Einzelverarbeitung von Filmmontierten integrierten Schaltkreisen.**

(57) Die Erfindung bezieht sich auf eine Halterung für die Einzelverarbeitung von filmmontierten integrierten Schaltkreisen. Diese Halterung, die in ihren äußeren Abmessungen einem Diarahmen entspricht, enthält in der Mitte ein Fenster (5) und an den Längsseiten Nasen (2, 3, 4,) die in die Perforation (12) des Filmträgers (11) eines filmmontierten integrierten Schaltkreises (13) so einrastbar sind, daß der filmmontierte integrierte Schaltkreis (13) im Fenster (5) zu liegen kommt. Dadurch erhält man eine gut haltbare Transport- und Lagereinheit.

FIG 2

0087797

SIEMENS AKTIENGESELLSCHAFT          Unser Zeichen
Berlin und München                  VPA 82 P 1 1 4 4 E

Halterung für die Einzelverarbeitung von filmmontierten
integrierten Schaltkreisen.

Die Erfindung betrifft eine Halterung für die Einzelverarbeitung von filmmontierten integrierten Schaltkreisen.

Zur gehäuselosen Montage eines integrierten Schaltkreises
(Chips) werden diese auf einem Filmträger aufgebracht,
auf dem der Außenkontaktierungsbereich (Outer-Lead)
bereits aufgebracht ist. Ein solcher Baustein, der
also aus der intergrierten Schaltung (Chips) und dem
Filmträger besteht, wird häufig auch als sogenanntes
Mikropack bezeichnet.

Bei der Filmmontage ist dabei folgender Verfahrensablauf
möglich. So kann z. B. die Rolle-zu-Rolle-Verarbeitung
vorgesehen sein, bei der bei allen Verarbeitungsschritten
die Zuführung der Filmträger bzw. der sogenannten Mikropacks von einer Rolle erfolgt, wobei nach dem Verarbeitungsschritt wieder auf eine Rolle aufgewickelt wird.

Abgesehen davon, daß die einzelnen Mikropacks bei einer
derartigen Bearbeitungsweise leicht beschädigt werden
können, ist diese auch dann sehr nachteilig, wenn mechanisch gleiche, aber in der elektrischen Funktion unterschiedliche Mikropacks auf ein und dieselbe Verdrahtungsplatte montiert werden müssen.

Aufgabe der vorliegenden Erfindung ist es, eine Halterung
anzugeben, durch die die Bearbeitungsmöglichkeiten für
filmmontierte integrierte Schaltungen verbessert werden.

Zk 1 Fdl/ 2. 3. 1982

BAD ORIGINAL

Zur Lösung dieser Aufgabe wird die Halterung gemäß der Erfindung derart ausgebildet, daß auf einer in der Mitte mit einem Fenster versehenenund von einem rundum laufenden dickeren Rahmen eingefaßtenrechteckförmigenPlatte entlang der beiden Längsseiten im Abstand der beiden Perforationsreihen des Filmträgers für die integrierten Schaltkreise im Perforationsraster je zwei Paare von Nasen angeordnet sind, wobei die Nasen etwa um die Trägerfoliendicke gegenüber der Plattenfläche erhöht, unsymmetrisch zu ihrer vertikalen Mittelachse, zueinander entgegengesetzt und parallel zur Plattenfläche von Stützen getragen sind, die etwa in einem Abstand voneinander angeordnet sind, der dem Abstand von der Vorderseite einer Perforationslochung des Trägerfilms zur Rückseite der darauffolgenden Perforationslochung entspricht, daß zwischen den beiden Stützen der Nasen jeweils eines Paares ein Durchbruch vorgesehen ist und daß das Fenster so groß bemessen ist, daß der äußere Kontaktierungsbereich des filmmontierten integrierten Schaltkreises bei der Montage von beiden Seiten frei zugänglich ist.

Die Halterung nach der Erfindung ermöglicht eine Rollenrahmenverarbeitung, d. h. beim ersten wesentlichen Verarbeitungsschritt der inneren Kontaktierung wird eine Rolle mit Mikropack erzeugt,für den weiteren Ablauf der Verarbeitung werden die Mikropacks jedoch vereinzelt in Rahmen, die in ihren äußeren Abmessungen sogenannten Diarahmen entsprechen, eingelegt. Der Einsatz derartiger Halterungen ist besonders dann vorteilhaft, wenn vor dem Bestücken eine bestimmte Sequenz von Funktionshüben gebildet werden muß, um einen kontinuierlichen Montageablauf durchführen zu können. Darüber hinaus bildet ein solcher Rahmen eine gut handbare Transport- und Lagereinheit und eignet sich gut für organisatorisch und technisch bedingte Kennzeichnungen, wie z. B. Beschriftungen.

Wenn man entsprechend dem Perforationsraster des Filmträgers weitere Nasenpaare mit entsprechenden Nasen
und Durchbrüchen vorsieht, so ist es möglich, unterschiedlich lange Mikropacks in die jeweilige Halterung
einzulegen.

In der Platte können weitere Durchbrüche vorgesehen
sein, die an der gleichen Stelle liegen wie die im
Filmträger befindlichen Justierfenster. Dadurch wird
der Zugriff zu den im Filmträger befindlichen Justierfenstern für die Außenkontaktierungsbereichmontage
ermöglicht.

Sieht man in dem umlaufenden Rahmen mindestens einen
nach innen weisenden Vorsprung vor, so wird dadurch ein
falsches Einlegen des Mikropacks in die Halterung verhindert.

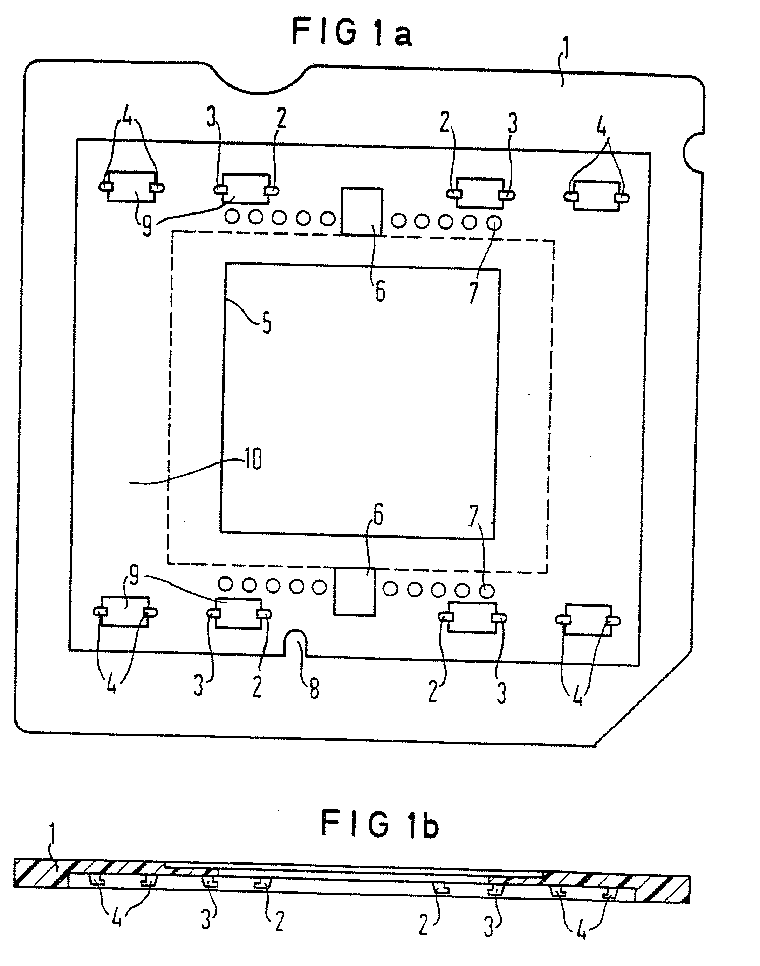

Anhand der Ausführungsbeispiele nach den Figuren 1 und
2 wird die Erfindung näher erläutert. Es zeigen:
Fig. 1 eine Halterung ohne filmmontierten Schaltkreis,
Fig. 2 eine Halterung mit einem bereits eingerasteten
       filmmontierten integrierten Schaltkreis.

Eine rechteckige Platte 10 nach Fig. 1, die von einem
dickeren Rahmen 1 umgeben ist, weist in ihrer Mitte
ein Fenster 5 auf. Unterhalb des dickeren Rahmens entlang der beiden Längsseiten befinden sich jeweils zwei
Nasenpaare mit den Nasen 2 und 3, zwischen denen ein
Durchbruch 9 angeordnet ist. Die Halterung entspricht
dabei in ihren äußeren Abmessungen dem üblichen Diarahmen in der Fototechnik. Zur Befestigung des Mikropacks
dienen Nasen, die in die Perforation des Filmträgers eingreifen. Die Nasen 2 sind dabei so ausgelegt, daß das
Mikropack in Position gehalten wird, die Nasen 3 sorgen
für die Planlage des Mikropacks im Rahmen. Durch die
Anordnung von weiteren Nasen 4 im Abstand der Perforation

0087797

lassen sich unterschiedlich lange Mikropacks in den Rahmen einlegen.

Die Nasen sind über Durchbrüche 9 angeordnet, durch die von der Rückseite her der Filmträgerrest nach der Montage des Mikropacks zur Wiederverwendung des Rahmens auf einfache Weise herausgedrückt werden kann. Die Nasen 2, 3 und 4 sind in der unterhalb der Draufsicht angeordneten Querschnittszeichnung in ihrer Ausgestaltung zu erkennen. Sie sind dabei hakenförmig ausgestaltet, wobei der Rücken dieser Haken eine leichte Schrägung aufweist. Die Nasen selbst werden dabei von einem Stützteil getragen, das unsymmetrisch zur Nase angeordnet ist.

Das zentral angeordnete Fenster 5 ist so bemessen, daß der äußere Kontaktbereich des Mikropacks bei der Montage von beiden Seiten frei zugänglich ist.

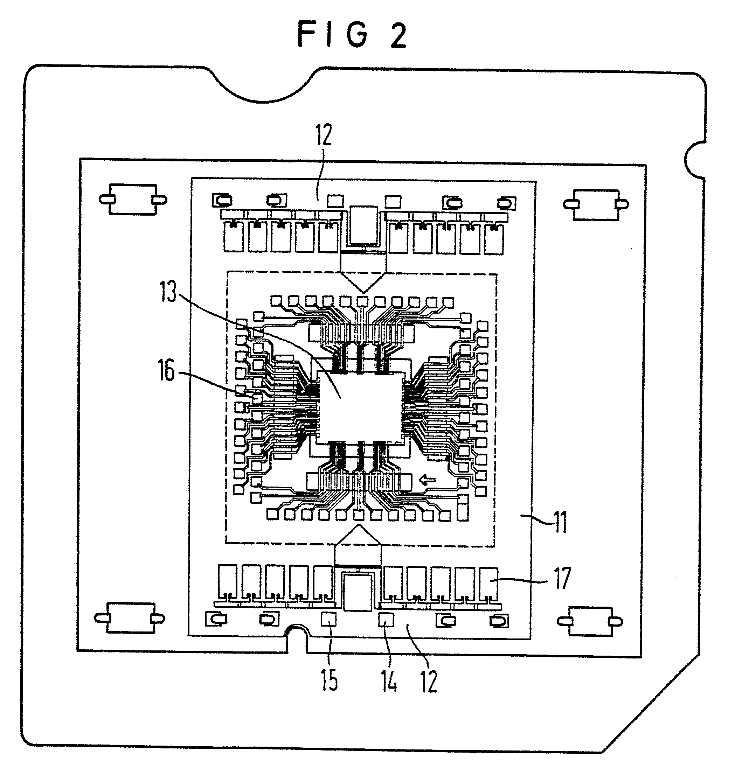

Die weiteren Durchbrüche 6 erlauben den Zugriff zu den im Filmträger befindlichen Justierfenstern für die Außenkontaktierungsmontage. (Vergl. Fig. 2). Die Lochreihen 7 dienen zum Lesen der in den Filmträger eingebrachten Kodieröffnungen 17 und sind entsprechend der Anordnung der Kodierstruktur auf dem Filmträger in Reihe mit den Justierfenstern angeordnet. Der Vorsprung 8 verhindert ein falsches Einlegen des Mikropacks in den Rahmen.

Der Werkstoff (Kunststoff) ist so gewählt, daß zum einen eine gute mechanische Stabilität erreicht wird (Verformungssteifigkeit), zum andern die Nasen noch ausreichend elastisch sind, daß beim Einlegen des Mikropacks die Perforation nicht beschädigt wird bzw. die Nasen beim Entfernen des Filmträgers aus dem Rahmen nicht abbrechen.

Zum Schutz gegen elektrostatische Aufladung des Rahmens
kann der Werkstoff mit entsprechenden Eigenschaften
versehen sein. So ist z. B. eine Füllung mit Kohlenstoff-
fasern günstig.

2 Figuren
4 Patentansprüche

Patentansprüche

1. Halterung für die Einzelverarbeitung von filmmontierten integrierten Schaltkreisen, d a d u r c h   g e k e n n - z e i c h n e t, daß eine in der Mitte mit einem Fenster (5) versehene und von einem rundum laufenden dickeren Rahmen (1) eingefaßte rechteckförmige Platte (10) entlang der beiden Längsseiten im Abstand der beiden Perforationsreihen (12) des Filmträgers (11) für die integrierten Schaltkreise (13) im Perforationsraster je zwei Paare von Nasen (2,3) enthält, wobei die Nasen (2, 3) etwa um die Trägerfoliendicke gegenüber der Platten- fläche erhöht, unsymmetrisch zu ihrer vertikalen Mittelachse, zueinander entgegengesetzt und parallel zur Platten- fläche von Stützen getragen sind, die etwa in einem Abstand voneinander angeordnet sind, der dem Abstand von der Vorderseite einer Perforationslochung (14) des Trägerfilms (11) zur Rückseite (15) der darauffolgenden Perforationslochung entspricht, daß zwischen den beiden Stützen der Nasen (2,3) jeweils eines Paares ein Durchbruch (9) vorgesehen ist und daß das Fenster (5) so groß bemessen ist, daß der äußere Kontaktierungsbereich (16) des filmmontierten integrierten Schaltkreises (13) bei der Montage von beiden Seiten frei zugänglich ist.

2. Halterung nach Anspruch 1, d a d u r c h   g e k e n n - z e i c h n e t, daß im Perforationsraster weitere Nasenpaare mit Nasen (4) und Durchbrüchen (9) vorgesehen sind.

3. Halterung nach einem der vorhergehenden Ansprüche, d a d u r c h   g e k e n n z e i c h n e t, daß in der Platte (10) weitere Durchbrüche (16) vorgesehen sind, die an der gleichen Stelle liegen wie die im Filmträger (11) befindlichen Justierfenster für die Außenkontaktierung der integrierten Schaltkreise (13).

4. Halterung nach einem der vorhergehenden Ansprüche,
d a d u r c h   g e k e n n z e i c h n e t, daß
in dem umlaufenden dickeren Rahmen (1) mindestens ein
nach innen weisender Vorsprung (8) eingearbeitet ist.

FIG 1a

FIG 1b

F I G 2